(19) **Europäisches Patentamt**
**European Patent Office**
**Office européen des brevets**

(11) **EP 2 265 478 B1**

(12) **EUROPÄISCHE PATENTSCHRIFT**

(45) Veröffentlichungstag und Bekanntmachung des Hinweises auf die Patenterteilung:
**26.09.2012 Patentblatt 2012/39**

(51) Int Cl.:
**B60T 8/36** *(2006.01)* **G01D 1/02** *(2006.01)*
**H03K 5/08** *(2006.01)* **H03M 3/02** *(2006.01)*

(21) Anmeldenummer: **09726060.8**

(86) Internationale Anmeldenummer:
**PCT/EP2009/053537**

(22) Anmeldetag: **25.03.2009**

(87) Internationale Veröffentlichungsnummer:
**WO 2009/118351 (01.10.2009 Gazette 2009/40)**

(54) **ELEKTRONISCHES KRAFTFAHRZEUGREGELUNGSSYSTEM MIT STROMMESSSCHALTUNG**

ELECTRONIC MOTOR VEHICLE CONTROL SYSTEM WITH CURRENT MEASURING CIRCUIT

SYSTÈME ÉLECTRONIQUE DE RÉGULATION D'UN VÉHICULE AUTOMOBILE AVEC CIRCUIT DE MESURE DE COURANT

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **27.03.2008 DE 102008015841**

(43) Veröffentlichungstag der Anmeldung:
**29.12.2010 Patentblatt 2010/52**

(73) Patentinhaber: **Continental Teves AG & Co. oHG 60488 Frankfurt (DE)**

(72) Erfinder:
• **OEHLER, Peter**
**60314 Frankfurt (DE)**
• **MICHEL, Frank**
**61191 Rosbach v.d.Höhe (DE)**

• **HEINZ, Micha**
**64289 Darmstadt (DE)**
• **SCHMITZ, Axel**
**Hattersheim 65795 (DE)**

(56) Entgegenhaltungen:
**WO-A-2004/030211        WO-A-2007/131947
DE-A1-102007 001 458**

• **AXEL MERTENS ET AL: "Voltage and Current Sensing in Power Electronic Converters Using Sigma-Delta A/D Conversion" IEEE TRANSACTIONS ON INDUSTRY APPLICATIONS, IEEE SERVICE CENTER, PISCATAWAY, NJ, US, Bd. 34, Nr. 5, 1. Oktober 1998 (1998-10-01), XP011022452 ISSN: 0093-9994**

**Beschreibung**

Die Erfindung betrifft ein elektronisches Kraftfahrzeugregelungssystem gemäß Oberbegriff von Anspruch 1, ein Verfahren zur Strommessung gemäß Oberbegriff von Anspruch 11, sowie die Verwendung des elektronischen Kraftfahrzeugregelungssystems in Kraftfahrzeugbremssystemen.

In den Druckschriften DE 100 57 486 A1 und DE 10 2007 001 458 A1 werden Ventilansteuerungsschaltungen in elektronischen Reglern für Kraftfahrzeugbremssysteme vorgeschlagen, welche mittels Puls-Weiten-Modulation (PWM) den durch eine im Wesentlichen induktive Last fließenden Laststrom regelt. Die Ansteuerschaltung weist eine elektronische Strommessschaltung mit einem Einschaltpfad und einem Rezirkulationspfad auf, wobei diese beiden Messpfade jeweils einen Sigma-Delta-Modulator umfassen.

Eine Aufgabe der vorliegenden Erfindung besteht darin, ein elektronisches Kraftfahrzeugregelungssystem und ein Verfahren zur Strommessung innerhalb eines elektronischen Kraftfahrzeugregelungssystems mit PWM-Stromregelung vorzuschlagen, mit dem eine Strommessung mit höherer Genauigkeit gegenüber bestehenden Schaltungen durchgeführt werden kann.

Diese Aufgabe wird erfindungsgemäß gelöst durch das elektronische Kraftfahrzeugregelungssystem gemäß Anspruch 1 und das Verfahren gemäß Anspruch 11.

Der Erfindung liegt der Gedanke zu Grunde, dass es vorteilhaft sein kann, das gemessene analoge Stromsignal des Laststroms für eine bestimmte Zeit zu halten bzw. zu speichern, ohne dass in dieser Halte- oder Speicherzeit eine Strommessung erfolgt bzw. der aktuell gemessene Strom bei der Ausgabe an weitere Schaltungsteile berücksichtigt wird. Nach der Haltezeit wird die Strommessung wieder fortgesetzt bzw. erneut berücksichtigt.

Unter einem Messsignal des Laststroms, der durch die vorzugsweise im wesentlichen induktive Last fließt, wird ein Signal verstanden, welches vom Laststrom abhängig ist, und vorzugsweise durch Skalierung des Laststroms erzeugt wird, wie beispielsweise mittels eines Sense-FETs, und/oder welches insbesondere ein Spannungssignal ist, das über einem Shunt abgreifbar ist, der vom Laststrom durchflossen wird. Besonders bevorzugt fallen Signale unter diesen Begriff, welche den zeitlichen Verlauf einer Messgröße des Laststroms abbilden oder bezüglich mindestens einer Größe vom Laststrom abhängig sind. Alternativ fällt unter oben genannten Begriff auch das Laststromsignal an sich oder vorzugsweise ein anderes vom Laststrom abhängiges Signal, welches zur Messung des Laststroms vorgesehen ist.

Unter einer Ventilansteuerungsschaltung wird bevorzugt eine Schaltung verstanden, welche zumindest den Strom durch ein Ventil, vorzugsweise ein Hydraulikventil, welches eine im Wesentlichen induktive elektrische Last darstellt, regelt. Dabei verwendet die Ventilansteuerungsschaltung insbesondere eine Puls-Weiten-Modulation und weist zumindest einen Einschaltpfad mit einem Leistungstreiber und einen Rezirkulationspfad mit einem Leistungstreiber auf. Besonders bevorzugt wird unter einer Ventilansteuerungsschaltung eine PWM-Endstufe verstanden.

Unter dem Formfehler wird die Abweichung zwischen tatsächlichem Mittelwert oder Effektivwert des Laststroms und dem nach der jeweiligen Strommessmethode erhaltenen, gemittelten Messwert über den Laststrom verstanden.

Der, insbesondere jeweilige, Analog-Digital-Wandler ist vorzugsweise als Sigma-Delta-Modulator ausgebildet. Dabei führt die elektronische Strommessschaltung eine Strommessung des Laststroms durch Überabtastung des analogen Messsignals des Laststroms durch, bei der die Taktrate des jeweiligen Sigma-Delta-Modulators deutlich größer ist als die Frequenz der Puls-Weiten-Modulation.

Der Einsatz eines Sigma-Delta-Modulators hat zum einen den Vorteil, dass ein Laststrom durch Überabtastung eines analogen Messsignals des Laststroms gemessen werden kann, wodurch mehrere Stromwerte pro PWM-Periode erfasst werden und somit Formfehler verringert oder vermieden werden können. Zum anderen sind Sigma-Delta-Modulatoren relativ kostengünstig, weil ihr Auflösungsvermögen nicht nur von der Ordnung abhängt, sondern vor allem von der Taktrate, mit welcher diese betrieben werden und somit auch Modulatoren kleiner Ordnung verwendet werden können. So ist es bevorzugt, mindestens einen 1-bit Sigma-Delta-Modulator zur Strommessung einzusetzen, welcher besonders wenige Halbleiterelemente erfordert, damit günstig ist und dennoch eine hohe Auflösung über die Taktrate erreichen kann. Aufgrund dessen, dass solch ein Analog-/Digitalwandler relativ kostengünstig ist, kann davon zweckmäßigerweise mindestens einer in jeder Strommessschaltung, insbesondere jeweils einer pro PWM-Pfad, verwendet werden, wodurch eine komplexe und damit relativ aufwändige Prioritätslogik zur Ansteuerung eines einzelnen Analog- /Digitalwandlers seitens aller im Kraftfahrzeugregelungssystem enthaltenen Strommessschaltungen, überflüssig wird. Die Strommessung durch den Sigma-Delta-Modulator erfolgt vorzugsweise direkt, also ohne Umwandlung des Stroms in eine entsprechende Spannung.

Die mindestens eine elektronische Strommessschaltung ist bevorzugt in der mindestens einen Ventilansteuerungsschaltung integriert beziehungsweise wird von dieser umfasst.

Es ist bevorzugt, dass die mindestens eine elektronische Strommessschaltung als integrierte Schaltung ausgebildet ist und insbesondere in dem elektronischen Kraftfahrzeugregelungssystem, welches auch als integrierte Schaltung ausgebildet ist, integriert ist.

Die Ventilansteuerungsschaltung ist bevorzugt so ausgelegt bzw. wird so betrieben, dass die Flanken des Laststroms hinsichtlich der Umschaltvorgänge zwischen den PWM-Phasen relativ geringe Steigungen aufweisen, insbesondere eine Steigung von weniger als 5A/$\mu$s, besonders bevorzugt von weniger als 3A/$\mu$s, damit die Abstrahlung besonders hochfrequenter elektromagnetischer Strahlung relativ gering gehalten wird.

Die Signal-Konservations-Schaltung umfasst bevorzugt ein elektronisches Speicherelement, wie zum Beispiel einen Kondensator, mit dem ein den aktuellen Strom repräsentierendes elektrisches Signal für eine vorübergehende Zeit gespeichert werden kann.

Die Signal-Konservations-Schaltung weist gemäß der Ausführungsform (jeweils) einen Eingangs-und einen Ausgangsschalter auf, welche beispielsweise durch Treiberschaltungen realisiert sind, wobei mit dem Eingangsschalter die Signal-Konservations-Schaltung von dem Laststrom bzw. einem direkten oder indirekten Laststromsignal, durch Öffnen dieses Schalters getrennt werden kann und somit das analoge Messsignale im Wesentlichen unverändert gehalten werden kann. Mit dem Ausgangsschalter kann die Signal-Konservations-Schaltung durch Öffnen dieses Schalters von dem jeweiligen Analog-Digital-Wandler getrennt werden.

Der mindestens eine Messpfad der elektronischen Strommessschaltung umfasst vorzugsweise eine Eingangsschaltung, die wenigstens einen Sense-FET, insbesondere einen Sense-Verstärker, aufweist, welcher das analoge Messsignal des Laststroms in Abhängigkeit des Laststroms bereitstellt.

Die elektronische Strommessschaltung weist zweckmäßigerweise zumindest einen Einschaltpfad und/oder wenigstens einen Rezirkulationspfad als Messpfade auf, wobei wenigstens einer oder beide jeweils wenigstens einen Analog-Digital-Wandler umfassen. Es ist dabei besonders zweckmäßig, wenn jeder Messpfad eine eigene Signal-Konservations-Schaltung umfasst.

Die wenigstens eine Ventilansteuerungsschaltung umfasst bevorzugt also entweder nur einen Einschaltpfad, bei dem die Rezirkulation über eine Freilaufdiode fließt, oder einen aktiven Einschalt- und einen aktiven Rezirkulationspfad, insbesondere mit jeweils zumindest einem Leistungstreiber zum Ein- bzw. Ausschalten dieses Pfades.

Es ist bevorzugt, dass der Einschaltpfad und/oder der Rezirkulationspfad der Strommessschaltung jeweils eine Eingangsschaltung aufweisen, der/die so angesteuert wird/werden, dass die Eingangsschaltung des Einschaltpfades im Wesentlichen nur während oder während eines Teils der Einschaltphase (oder je nach Ausführungsform nur während oder während eines Teils der Ausschaltphase) den tatsächlichen Laststrom direkt oder indirekt diesem Messpfad bereitstellt.

Nach einer ersten bevorzugten Ausführungsform befinden sich sowohl im Einschaltpfad als auch im Ausschaltpfad die oben beschriebenen Strommesseinrichtungen. Dabei erfolgt zweckmäßigerweise jeweils beim Umschalten von Einschaltphase auf Rezirkulationsphase eine Aktivierung der Signal-Konservations-Schaltung, wobei der Strom eine definierte Haltezeit gehalten wird oder bis die Spannung über dem wenigstens einen Leistungstreiber, insbesondere dem Einschalttreiber oder Rezirkulationstreiber, der Ventilansteuerungsschaltung in definierter Weise eingeschwungen ist oder eine definierte Schwellspannung über- oder unterschritten ist. Während der Konservations-Phase wird der ausgegebene Strom im Wesentlichen unverändert gehalten und zur weiteren Verarbeitung (Strommessung) bereitgestellt.

Die Eingangsschaltung stellt nach einer zweiten bevorzugten Ausführungsform, welche erheblich kostensparender ist, den tatsächlichen (momentanen) Strom des Einschaltpfads oder des Rezirkulationspfades nur für eine bestimmte vorgegebene Zeitspanne bereit, welche zweckmäßigerweise im wesentlichen mit dem Beginn einer jeden PWM-Periode startet, wobei genau betrachtet diese insbesondere erst dann startet, wenn das Strommesssignal eingeschwungen ist. Bevorzugt beginnt die Haltephase, in der die Konservationsschaltung den zuletzt gespeicherten Strommesswert ausgibt, zu einem vorgegebenen Zeitpunkt, welcher zwischen einiger Zeit nach Beginn der PWM-Periode und einiger Zeit vor dem Ablauf der Einschaltphase liegt. Besonders bevorzugt wird der Strom im Einschaltpfad ab Beginn (bzw. kurz danach) einer jeden PWM-Periode gemessen und weitergegeben. Der Startzeitpunkt der Haltephase richtet sich dabei nach einer geeigneten Zeitbasis. Die Zeitbasis ist entweder die PWM-Periode oder der Tastgrad oder davon abgeleitet. Besonders bevorzugt wird als Zeitbasis sowohl die PWM-Periode als auch der Tastgrad herangezogen. Der Startzeitpunkt liegt vorzugsweise in einem Bereich zwischen etwa 5 bis 80 Prozent des Tastgrads der PWM. Ganz besonders bevorzugt liegt der Zeitpunkt entsprechend einem Tastgrad der PWM (dutycycle) in einem Bereich von etwa 16 bis 40 Prozent. Dabei gilt: $Tastgrad = \dfrac{t_i}{T}$, worin $t_i$ die Impulsdauer und $T$ die Periodendauer ist. Es hat sich herausgestellt, dass ein Bereich für den Tastgrad von etwa 26 bis 30 Prozent am vorteilhaftesten ist. Legt man den Zeitpunkt des Beginns der Haltephase wie vorstehend beschrieben fest, ist der nachfolgend definierte Formfehler auch bei sich ändernden Randbedingungen (unterschiedliche Lasten und Umgebungsbedingungen) erstaunlich gering.

Die Haltephase endet bei der zweiten bevorzugten Ausführungsform nach Ablauf der ganzen PWM-Periode (nach einer Einschalt- und Rezirkulationsphase). Der sich durch die fehlende Messung während eines Teils der Einschaltphase und der ganzen Ausschaltphase ergebende Fehler mittelt sich so auf vorteilhafte Weise aus dem Messergebnis heraus.

Insbesondere weisen die Eingangsschaltungen des Einschaltpfades und/oder des Rezirkulationspfades jeweils wenigstens einen Sense-FET, insbesondere einen Sense-Verstärker auf, welcher das analoge Messsignal des Laststroms in Abhängigkeit des tatsächlichen Laststroms bereitstellt. Dabei ist der Gateanschluss dieses mindestens einen Sense-FETs besonders bevorzugt mit dem Gateanschluss mindestens eines Leistungstreibers des Einschaltpfades oder des Rezirkulationspfades verbunden. Zusätzlich sind die Drainanschlüsse und/oder die Sourceanschlüsse des jeweiligen Sense-FETs und des jeweiligen Leistungstreibers direkt oder indirekt miteinander verbunden oder gekoppelt. Diese Ausbildung der elektronischen Strommessschaltung erlaubt eine indirekte Strommessung, wobei der wirklich zu messende Strom um einen definierten Faktor geringer ausfällt, was es erlaubt, die messenden Bauelemente nicht unbedingt für Leistungsanwendungen auszulegen bzw. dies ist nur in entsprechend geringerem Maße erforderlich.

Es ist zweckmäßig, dass der mindestens eine Sigma-Delta-Modulator, insbesondere jeweils, aus einem Regelkreis besteht, welcher ein Integratorelement, insbesondere einen Integrator, besonders bevorzugt einen Kondensator oder ein anderes Bauelement oder eine elektronische Schaltung mit entsprechendem elektrischen Verhalten, einen Komparator und eine, insbesondere steuerbare, schaltbare Stromquelle aufweist. Diese schaltbare Stromquelle ist besonders bevorzugt so ausgebildet, dass sie verschiedene diskrete Stromwerte treiben kann und zwischen diesen verschiedenen Stromwerten umgeschaltet werden kann. Ganz besonders bevorzugt besteht diese schaltbare Stromquelle aus einer Parallelschaltung von Stromquellen, deren Ströme in definierter Weise addiert werden können und dieser Vorgang insbesondere vorzugsweise schaltbar ist.

Es ist bevorzugt, dass der wenigstens eine Analog-Digital-Wandler zumindest ein Speicherelement, welches wenigstens eine Information über das analoge Messsignal des Laststroms direkt oder indirekt speichern kann, und zumindest bei der ersten bevorzugten Ausführungsform wenigstens einen Schalter umfasst, wobei mittels dieses Schalters das Speicherelement, insbesondere elektrisch, isoliert werden kann und insbesondere der Analog-Digital-Wandler außer Funktion gesetzt werden kann. Insbesondere ist das Speicherelement ein Kondensator bzw. eine Kapazität bzw. ein Integratorelement eines Sigma-Delta-Modulators und der Schalter schaltet eine schaltbare Stromquelle dieses Sigma-Delta-Modulators.

Der Ausgang des mindestens einen Sigma-Delta-Modulators ist vorzugsweise an mindestens eine Mittelwertbildungseinrichtung angeschlossen. Insbesondere ist diese Mittelwertbildungseinrichtung ein Zählerelement bzw. ein "moving average filter" oder alternativ ein exponentiell gewichtetes, gleitendes Mittelwert-Filter (exponentially weighted moving average filter), das sich wie ein digitales Tiefpassfilter erster Ordnung verhält. Besonders bevorzugt ist das Zählerelement eine Schaltung, welche so ausgelegt ist oder angesteuert wird, dass diese digitale Daten aufsummiert. Ein solcher Zähler bzw. solches Zählerelement führt implizit eine Mittelwertbildung durch, da alle Daten des Sigma-Delta-Modulators pro Takt von diesem aufsummiert und damit berücksichtigt werden.

Es ist zweckmäßig, dass die elektronische Strommessschaltung eine Umschalteinheit bzw. einen Multiplexer und eine gemeinsame Mittelwertbildungseinrichtung aufweist, wobei die Ausgänge des Einschaltpfades und des Rezirkulationspfades mit den Eingängen der Umschalteinheit verbunden und der Ausgang der Umschalteinheit mit dem Eingang der gemeinsamen Mittelwertbildungseinrichtung verbunden sind.

Die Erfindung betrifft auch ein Verfahren gemäß Anspruch 11.

Gemäß einer ersten bevorzugten Ausführungsform des Verfahrens wird zweckmäßigerweise der Laststrom während einer Einschaltphase und einer Rezirkulationsphase der PWM gemessen, wobei die elektronische Strommessschaltung hierzu zumindest einen Einschaltpfad und wenigstens einen Rezirkulationspfad als Messpfade aufweist, welche jeweils wenigstens einen Analog-Digital-Wandler und eine Signal-Konservations-Schaltung umfassen.

Dieses Verfahren wird vorzugsweise dadurch ergänzt, dass beim Umschalten zwischen den PWM-Phasen ein Eingangsschalter der Signal-Konservations-Schaltung des Messpfades, welcher der gerade beendeten PWM-Phase zugeordnet ist, geöffnet wird, wodurch das analoge Messsignal des Laststroms dieses PWM-Pfades im Wesentlichen für eine definierte Haltezeit unverändert bereitgestellt wird, wobei nach dieser definierten Haltezeit ein Ausgangsschalter dieser Signal-Konservations-Schaltung geöffnet wird, wodurch der A/D-Wandler eingefroren wird, und damit das Messsignal oder eine von diesem abhängige elektrische Größe direkt oder indirekt für die Dauer der gerade begonnenen PWM-Phase zuzüglich der sich an diese PWM-Phase anschließenden Haltezeit gespeichert wird.

Gemäß einer zweiten Ausführungsform des Verfahrens wird der Laststrom nur während eines Teils der Einschalt- und/oder Ausschaltphase bestimmt. Insbesondere erfolgt diese Strommessung nur während der Einschaltphase. Zweckmäßigerweise wird die Strommessung mit dem Beginn einer jeden PWM-Periode oder bei jeder geeigneten PWM-Periode gestartet. Das Verfahren gemäß der zweiten bevorzugten Ausführungsform lässt sich besonders zweckmäßig in Treiberschaltungen anwenden, bei denen lediglich der Ansteuerpfad ein aktives Bauelement umfasst, zumal das Verfahren gemäß der ersten bevorzugten Ausführungsform - wenn überhaupt - nur schwerlich eine Strommessung in der Rezirkulationsphase zulässt. Durch den Wegfall eines oder mehrerer aktiver Halbleiterelemente im Rezirkulationspfad bietet eine solche Ansteuerschaltung Kostenvorteile.

Die bei der zweiten bevorzugten Ausführungsform sich an die Strommessphase anschließende Haltephase beginnt bevorzugt bei einem Tastgrad der PWM, welcher in einem Bereich von etwa 5 bis 80 Prozent liegt.

Bei der zweiten bevorzugten Ausführungsform endet die Haltephase bevorzugt im Bereich des Endes der PWM-Periode (nach der Rezirkulationsphase).

Bei der ersten bevorzugten Ausführungsform beginnt die Haltephase (Phase des Messsignals) erst im Bereich des Übergangs von Einschaltphase zu Ausschaltphase bzw. umgekehrt (Phasen der Ansteuerung), wobei der genaue Zeitpunkt zweckmäßigerweise davon abhängt bzw. dadurch bestimmt wird, dass nach dem Umschalten eine definierte bzw. bestimmte Einschwingzeit vergeht, insbesondere bis die Spannung über dem jeweiligen Leistungstreiber der Einschaltpfades oder des Rezirkulationspfades eingeschwungen ist. Besonders bevorzugt hängt die Zeit für die Dauer der Haltephase (Haltezeit) von der Unterschreitung dieser jeweiligen Spannung gegenüber einer definierten Schwellspannung ab. Besonders bevorzugt wird bei Unter- oder Überschreitung dieser Schwellspannung die elektronische Strommessschaltung so angesteuert, dass die Haltephase beendet ist. Alternativ ergibt sich die Haltezeit aus dem Überschreiten einer definierten Spannungsschwelle durch die Gate- bzw. Basisspannung des jeweiligen Leistungstreiber des Einschalt- bzw. Rezirkulationspfades. Ganz besonders bevorzugt umfasst die Haltezeit eine zusätzliche Einschwingzeit der Eingangsschaltung des jeweiligen PWM-Pfades. Die Zeit der Haltephase ist bezüglich der Übergänge von Rezirkulationsphase zu Einschaltphase und Einschaltphase zu Rezirkulationsphase im Wesentlichen gleich lang oder alternativ vorzugsweise unterschiedlich lang.

Die Haltezeit bei der ersten bevorzugten Ausführungsform ergibt sich bevorzugt in Summe aus dem Zeitintervall beginnend mit dem Umschaltzeitpunkt der PWM und endend bei Unter- oder Überschreiten einer definierten Spannungsschwelle an dem jeweiligen oder einem der Leitungstreiber der Ventilansteuerungsschaltung und einem Zeitintervall, welches durch eine definierte Einschwingzeit des wenigstens einen Messpfades definiert ist. Alternativ ist die Haltezeit dabei vorzugsweise durch das Timing-Verhalten der Strommessschaltung und/oder der Ventilansteuerungsschaltung in definierter Weise, gemäß obig erläuterten Gesichtspunkten im Wesentlichen fest eingestellt.

Bei der ersten bevorzugten Ausführungsform ist es zweckmäßig, dass jeweils beim Umschalten zwischen den PWM-Phasen, direkt zu Beginn einer jeweiligen PWM-Phase, der Eingangsschalter der Signal-Konservations-Schaltung des jeweiligen PWM-Pfades geschlossen wird und der Ausgangsschalter dieser Signal-Konservations-Schaltung des einen PWM-Pfades jeweils dann im Wesentlichen geschlossen wird, wenn der Ausgangsschalter der Signal-Konservations-Schaltung des anderen PWM-Pfades geöffnet wird.

Es ist dabei bevorzugt, dass jeweils im Wesentlichen zeitgleich mit dem Öffnen des Ausgangsschalters der Signal-Konservations-Schaltung eines der Messpfade ein Schalter des Analog-Digital-Wandlers dieses Messpfades ebenfalls geöffnet wird und damit ein Speicherelement dieses Analog-Digital-Wandlers isoliert wird und dabei insbesondere dieser Analog-Digital-Wandler außer Funktion gesetzt wird, wobei dieser Schalter dieses Analog-Digital-Wandlers auch im Wesentlichen zeitgleich mit dem Ausgangsschalter der Signal-Konservations-Schaltung dieses Messpfades wieder geschlossen wird oder wieder zusätzlich ansteuerbar wird, wodurch dieser Analog-Digital-Wandler wieder in Funktion gesetzt wird. Durch das temporäre An- und Abschalten des Analog-Digital-Wandlers wird die Erzeugung unerwünschter Teilsignale des digitalen Messsignals des Laststroms vermieden. Durch die temporäre Isolation des Speicherelements des Analog-Digital-Wandlers mittels seines Schalters, wird während einer inaktiven Phase des jeweiligen Messpfades eine Änderung der in dem Speicherelement, welches insbesondere als Integrator eines Sigma-Delta-Modulators ausgebildet ist, direkt oder indirekt gespeicherten Information im Wesentlichen unverändert gehalten.

Die digitalen Messsignale der PWM-Pfade werden bevorzugt im Wesentlichen innerhalb des Zeitintervalls, in welchem der Ausgangsschalter der Signal-Konservations-Schaltung des jeweiligen PWM-Pfades geschlossen ist, an eine gemeinsame Auswerteschaltung übertragen oder von dieser berücksichtigt, wobei das Ausgangssignal dieser gemeinsamen Auswerteschaltung zumindest die Information über die Amplitude des gemessenen Laststroms, insbesondere jeweils hinsichtlich einer PWM-Periode, beinhaltet. Die gemeinsame Auswerteschaltung umfasst besonders bevorzugt eine gemeinsame Mittelwertbildungseinrichtung, die beispielsweise als Zähler ausgebildet ist. Demgegenüber kann bei der zweiten bevorzugten Ausführungsform der Ausgangsschalter entfallen, da der Sigma-Delta-Wandler permanent mitläuft.

Die Erfindung betrifft außerdem die Verwendung des elektronischen Kraftfahrzeugregelungssystems in einem Kraftfahrzeugbremssystem.

Das erfindungsgemäße elektronische Kraftfahrzeugregelungssystem sowie das erfindungsgemäße Verfahren werden bevorzugt in elektronischen Kraftfahrzeugbremssystemen, bei denen elektromagnetische Hydraulikventile über Puls-Weiten-Modulation in Ventilansteuerungsschaltungen angesteuert werden, zur Einstellung des Hydraulikdrucks in Radbremsen des Kraftfahrzeugs, verwendet. Alternativ ist eine Verwendung in einem servounterstützten Lenkungssystem eines Kraftfahrzeuges vorgesehen, wobei das erfindungsgemäße elektronische Kraftfahrzeugregelungssystem das mindestens eine Hydraulikventil ansteuert.

Weitere bevorzugte Ausführungsformen ergeben sich aus den Unteransprüchen und der nachfolgenden Beschreibung von Ausführungsbeispielen an Hand von Figuren.

Es zeigen in schematischer Darstellung

Fig. 1     ein Ausführungsbeispiel eines Stromverlaufs bei einer Schaltung mit Lowside- und Rezirku-

lationstreiber in einer Ventilansteuerungs-schaltung,

Fig. 2　　einen Einschaltpfad einer elektronischen Strommessschaltung,

Fig. 3　　einen korrespondierenden Rezirkulationspfade der Strommessschaltung,

Fig. 4　　Signalverläufe eines Übergangs von Rezirkulationsphase zu Einschaltphase, und

Fig. 5　　Signalverläufe eines Übergangs von Einschaltphase zu Rezirkulationsphase,

Fig. 6　　Signalverläufe und Strommessungen mit während der Einschaltphase beginnenden Haltephasen und

Fig. 7　　Signalverläufe und Strommessungen mit einer während der Ansteuerphase beginnenden Haltephase bei einem besonders geeigneten Tastgrad der PWM.

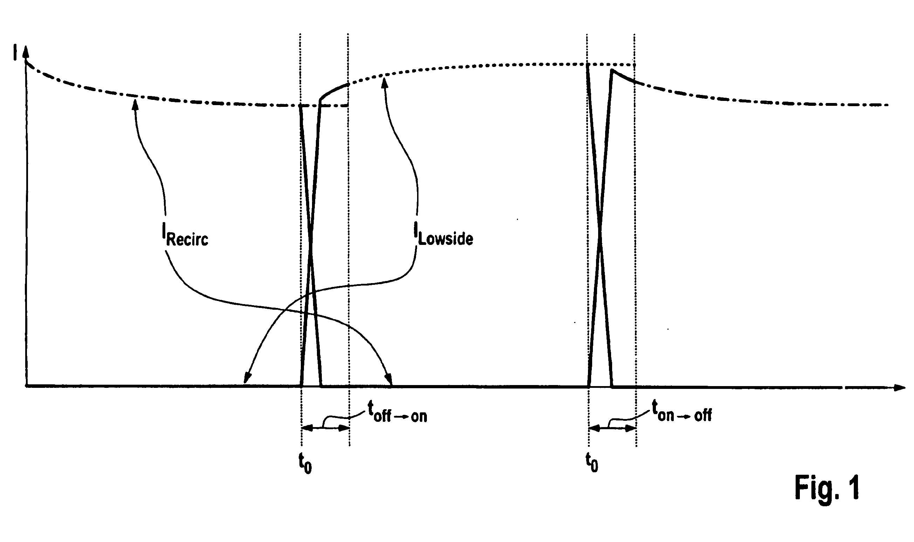

In Fig. 1 ist ein Ausführungsbeispiel eines typischen Stromverlaufs durch den Lowside- bzw. durch die Rezirkulationstreiber einer Ventilansteuerungsschaltung, also entsprechend den Leistungstreiber des Einschalt- und Rezirkulationspfades einer Ventilansteuerungsschaltung, dargestellt. Dabei entspricht dieser Strom im Wesentlichen dem Laststrom durch die Ventilspule bzw. ist von diesem abhängig. Die Stromverläufe von $I_{Recire}$ und $I_{Lowside}$ entsprechend dabei den zu messenden Strömen in der Rezirkulationsphase und in der Einschaltphase. Zum Zeitpunkt $t_0$ wird jeweils zwischen diesen beiden PWM-Phasen umgeschaltet. Dabei ist aus der Figur ersichtlich, dass in den Übergangsphasen $t_{off \to on}$ sowie $t_{on \to off}$, in welchen die Ventilschaltung sich noch in einem nicht eingeschwungenen Zustand befindet, die jeweiligen Ströme deutlich unterhalb eines mittleren Stromes liegen, was zu unerwünschten Messergebnissen führen kann. Aus diesem Grund wird beispielgemäß jeweils der Strom des gerade abgeschalteten Pfades durch eine Signal-Konservations-Schaltung unverändert bzw. konstant gehalten für eine definierte Haltezeit, welche der Dauer der Übergangsphasen $t_{off \to on}$ sowie $t_{on \to off}$ entspricht. Hierdurch kann der Mittelwert des Stroms durch mehrere Messpunkte pro PWM-Phase relativ präzise ermittelt werden. Die unverändert gehaltenen Ströme werden durch die gepunkteten bzw. strichgepunkteten Abschnitte innerhalb der Übergangsphasen $t_{off \to on}$, $t_{on \to off}$ veranschaulicht. Der analoge Messstrom, welcher insgesamt gemessen wird bei durchgehenden Messungen, ist durch den gepunkteten bzw. strichgepunkteten Verlauf über alle Abschnitte des Diagramms markiert. Das Ende der Übergangsphasen wird beispielgemäß dadurch definiert, dass die Spannung über dem jeweiligen Leitungstreiber des Einschaltpfades oder Rezirkulationspfades der Ventilansteuerungsschaltung eingeschwungen ist bzw. eine definierte Schwellspannung unterschreitet und zusätzlich eine definierte Einschwingzeit des Messpfades vergangen ist. Es hat sich herausgestellt und ist aus Fig. 1 ersichtlich, dass der beispielgemäß noch gemachte "Messfehler" innerhalb der Übergangsphasen alternierend positiv und negativ ist und der Differenzfehler somit sehr gering wird, falls die Dauer der Übergangsphasen sehr viel kürzer ist als die Periodendauer der PWM. Es ist also mit dieser Vorgehensweise vorteilhaft möglich auch präzise Messungen durchzuführen, wenn sich diese in zeitlicher Nähe von Umschaltvorgängen zwischen den beiden PWM-Phasen befinden.

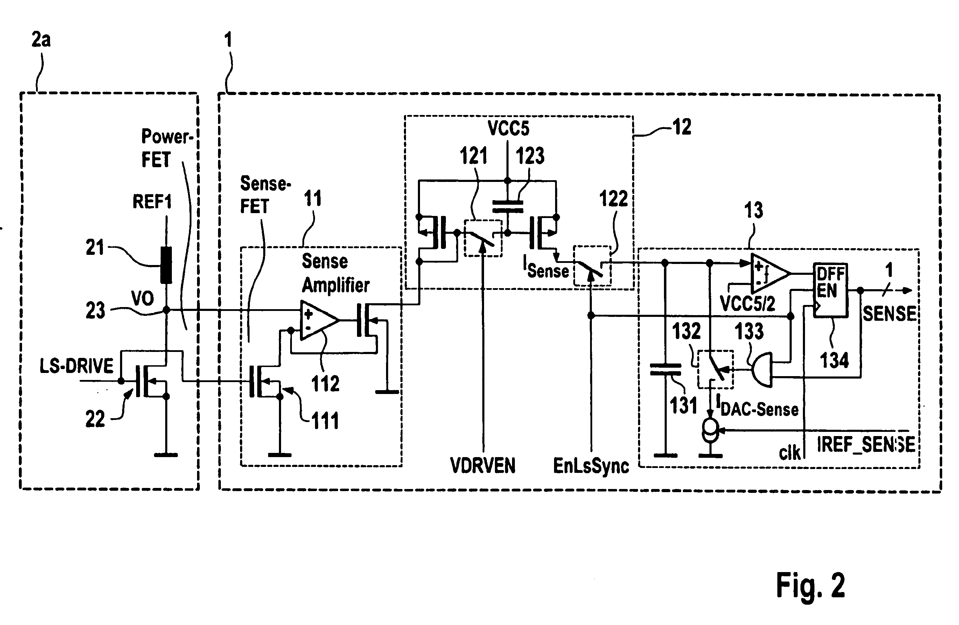

Fig. 2 zeigt einen beispielhaften Einschaltpfad 1, als Messpfad einer elektronischen Strommessschaltung, sowie den Einschaltpfad 2a einer beispielgemäßen Ventilansteuerungsschaltung. Dieser Einschaltpfad 2a der Ventilansteuerungsschaltung umfasst induktive Last bzw. Spule 21 des Ventils, sowie Leistungstreiber 22 des Einschaltpfades. An Spule 21 liegt einerseits Versorgungspotential REF1 und andererseits am Knotenpunkt 23 zwischen Spule 21 und Leistungstreiber 22 das Potential VO an. Am Gateanschluss Leistungstreibers 22 liegt Signal LS-DRIVE an, mit welchem Leistungstreiber 22 bei Aktivierung des Einschaltpfades durchgeschaltet wird. Einschaltpfad 1 der Strommessschaltung umfasst eine Eingangsschaltung 11 mit Sense-Verstärker 112 und Sense-FET 111, eine Signal-Konservations-Schaltung 12 mit Eingangsschalter 121, Ausgangsschalter 122 und Kapazität 123, sowie einen Sigma-Delta-Modulator 13. Leistungstreiber 22 mit Gateeingang LS-DRIVE und Eingangsschalter 121 mit Schaltsignal VDRVEN werden beispielgemäß gleichzeitig angesteuert, insbesondere gleichzeitig mit dem weiter unten beschriebenen Signal EnLsSync. Dadurch wird Signal-Konservations-Schaltung 12 durch Eingangsschaltung 11 von Beginn einer Einschaltphase bis zum Ende dieser Einschaltphase mit dem analogem Messsignal des Laststroms versorgt. Beim Umschalten von der Einschaltphase zur Rezirkulationsphase wird Eingangsschalter 121 geöffnet und Kapazität 123 speichert den zuletzt durch Eingangsschaltung 11 bereitgestellten Zustand des analogen Messsignals des Laststroms und gibt dieses Messsignal für eine definierte Haltezeit im Wesentlichen unverändert an Sigma-Delta-Modulator 13 weiter. Sigma-Delta-Modulator 13, welcher beispielgemäß als Regelkreis ausgebildet ist, umfasst Kondensator 131 als Integratorelement bzw. Integrator. Kondensator 131 dient dabei als Speicherelement, welches wenigstens eine Information über das zuletzt dem Sigma-Delta-Modulator 13 zur Verfügung gestellte analoge Messsignal des Laststroms bereitstellt. Durch das jeweilige Öffnen von Ausgangsschalter 122 der Signal-Konservations-Schaltung und Schalter 132 des Sigma-Delta-Modulators wird Speicherelement bzw. Kondensator 131 elektrisch isoliert. Schalter 132 dient dabei gleichzeitig als Schalter einer regelbaren Stromquelle des Sigma-Delta-Modulators 13. Mittels des Signals EnLsSync wird Schalter 132 zeitgleich mit Ausgangsschalter 122 am Ende der Haltezeit für eine definierte Zeitdauer zur Öffnung veranlasst. Signal-Konservations-Schaltung 12 und Kondensator bzw. Speicherelement 131 speichern jeweils den aktuellen, zuletzt bereitgestellten Zustand des analogen Messsignals des Laststrom ab. Signal-Konservations-Schaltung 12 speichert dabei beispielgemäß diesen letzten Zustand des analogen Messsignals bis zum Beginn der nächsten Einschaltphase und Kondensator 131 bis zum Ende der definierten Haltephase, welche sich an den Beginn der nächsten Einschaltphase anschließt. Signal EnLsSync veranlasst dabei wieder ein Schließen Ausgangsschalters 122 und ein Freigeben Schalters 132 wenn der entsprechende Ausgangsschalter der Signal-Konservations-Schaltung des Rezirkulationspfades geöffnet wird. Mittels des UND-Gatters 133, welches eingangsseitig mit Schaltsignal EnLsSync und dem Ausgang SENSE des Sigma-Delta-Modulators 13 verbunden ist, wird Schalter 132 ausgangsseitig angesteuert. Im Fall, dass Signal EnLsSync einer logischen "0" entspricht, ist Schalter 132 geöffnet und kann durch das digitale Messsignal des Laststroms SENSE nicht die Stromquelle des Sigma-Delta-Modulators frei umschalten, wodurch Sigma-Delta-Modulator 13 außer Funktion gesetzt ist. Im Fall, dass Signal EnLsSync einer logischen "1" entspricht, ist Ausgangsschalter 122 geschlossen und Schalter 132 nicht stets geöffnet, wobei Schalter 132 dabei in Abhängigkeit des digitalen Messsignals SENSE frei schaltbar ist bzw. angesteuert wird. Das Signal EnLsSync liegt dabei zusätzlich am "Setzen"-Eingang eines D-Flip-Flops 134 des Sigma-Delta-Modulators 13 an, wodurch Sigma-Delta-Modulator 13 zusätzlich bei einer logischen "0" des Signals EnLsSync außer Funktion gesetzt werden kann. Ein Betrieb der Schaltung ist alternativ auch ohne diese Signalleitung möglich. Sigma-Delta-Modulator 13 wird beispielgemäß mit einer viel größeren Taktfrequenz clk betrieben, als die Frequenz der PWM.

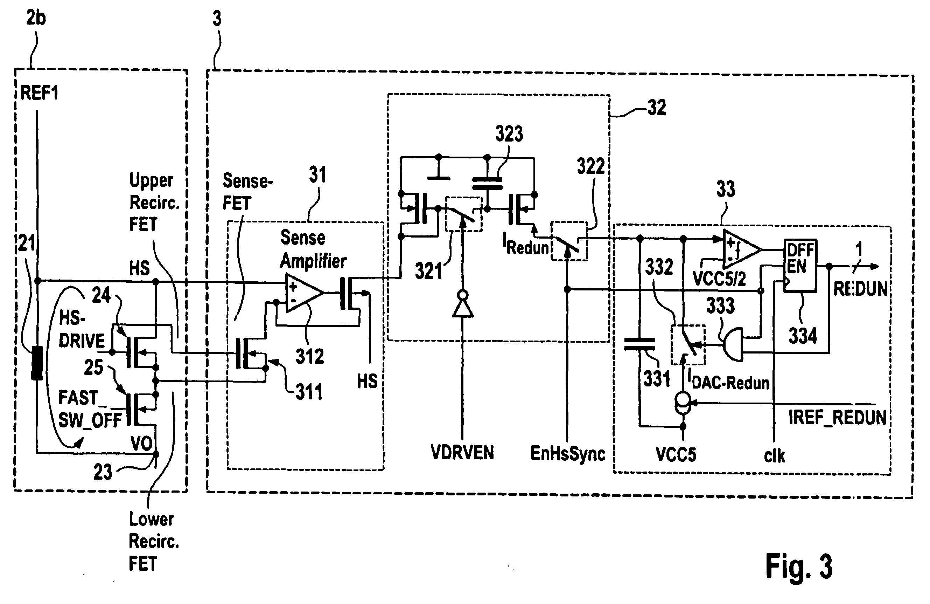

In Fig. 3 sind der beispielhafte Rezirkulationspfad 3, als Messpfad einer elektronischen Strommessschaltung, sowie der Rezirkulationspfad 2b einer beispielgemäßen Ventilansteuerungsschaltung veranschaulicht. Rezirkulationspfad 2b der Ventilansteuerungsschaltung weist dabei Spule 21 des Ventils, den Leistungstreiber des Rezirkulationspfades 24, welcher durch Signal HS-DRIVE gateseitig angesteuert wird, Knotenpunkt 23 mit Potential VO und einen zusätzlichen Leistungstreiber 25 zur Schnellabschaltung auf. Zur Bestimmung der Haltezeit wird beispielhaft die Spannung über Leistungstreiber 24 bzw. deren Unterschreitung einer definierten Schwellspannung oder die Überschreitung einer definierten Schwellspannung von HS-Drive betrachtet. Die Haltezeit dauert entsprechend vom Einschaltzeitpunkt des Leistungstreibers 24 bis zur Unter- bzw. Überschreitung obig erläuterter Schwellspannungen durch obig erläuterte Signale, wobei zusätzlich eine definierte Einschwingzeit des Messpfades abgewartet werden muss. Rezirkulationspfad 3 der Strommessschaltung umfasst ebenfalls eine Eingangsschaltung 31 mit Sense-Verstärker 312 und Sense-FET 311, eine Signal-Konservations-Schaltung 32 mit Eingangsschalter 321, Ausgangsschalter 322 und Kapazität 323, sowie einen Sigma-Delta-Modulator 33 mit digitalem Messsignal des Laststroms REDUN als Ausgangssignal. Eingangsschaltung 31 stellt das analoge Messsignal des Laststroms bereit. Eingangsschalter 321 wird von invertiertem Signal VDRVEN angesteuert und ist somit abwechselnd zu Eingangsschalter 121 aus Fig. 2 geöffnet bzw. geschlossen. Wenn Eingangsschalter 321 geschlossen ist, wird das analoge Messsignal des Laststroms im Wesentlichen unverändert zur Messung durch Sigma-Delta-Modulator 33 bereitgestellt. Nach erfolgter Umschaltung von Rezirkulationsphase zur Einschaltphase wird Ausgangsschalter 322 und Schalter 332 des Sigma-Delta-Modulators 33, veranlasst durch eine logische "0" des Signals EnHsSync, geöffnet bzw. für eine definierte Dauer mittels UND-Gatter 333, an welchem eingangsseitig Signal EnHsSync und das digitale Ausgangssignal REDUN des Sigma-Delta-Modulators 33 anliegen und das ausgangsseitig Schalter 332 ansteuert, stets geöffnet gehalten. Auch hier kann das Signal EnHsSync vorzugsweise gleichzeitig mit dem Signal VRDVEN angesteuert werden. Dadurch, dass die schaltbare Stromquelle des Sigma-Delta-Modulators 33 nicht frei schaltbar bzw. Schalter 332 schließbar ist und weil Signal EnHsSync zusätzlich am "Setzen-Eingang" eines D-Flip-Flops 334 des Sigma-Delta-Modulators 33 anliegt, ist Sigma-Delta-Modulator 33 bei einer "0" des Signals EnHsSync außer Funktion und stellt die Strommessung ein, bis Signal EnHsSync in der nächsten Rezirkulationsphase am Schluss der Haltephase des Einschaltpfades wieder einer logischen "1" entspricht und Ausgangsschalter 322 der Strommessschaltung dadurch wieder geschlossen wird, Schalter 332 wieder in Abhängigkeit des Signals REDUN frei schaltbar ist und am "Setzen"-Eingang des D-Flip-Flops 334 wieder eine "1" anliegt.

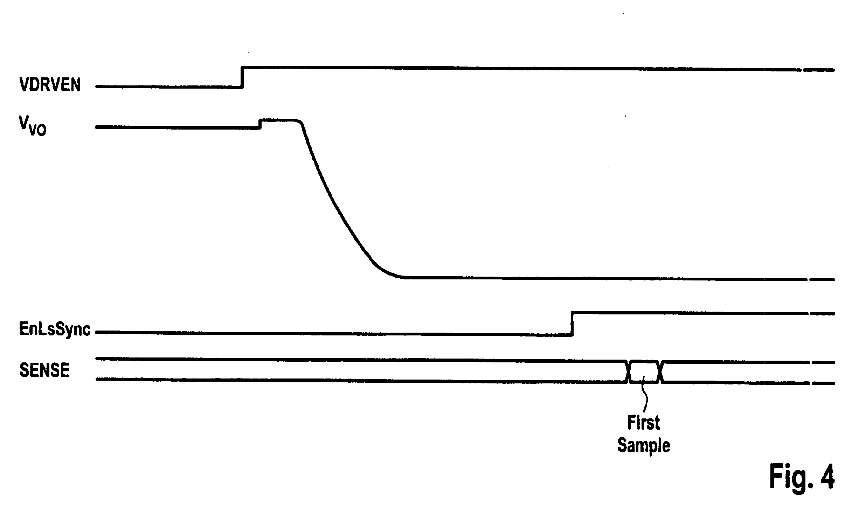

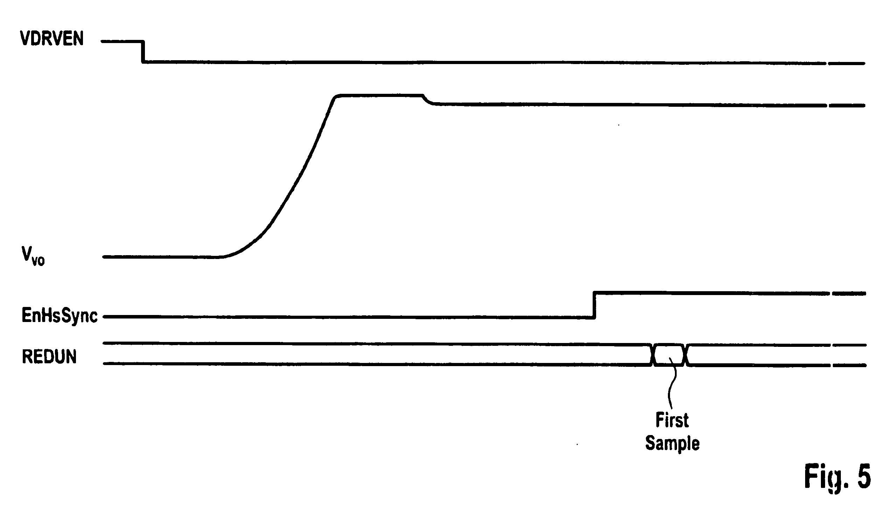

Fig. 4 zeigt beispielhafte Signalverläufe der Signale VDRVEN, $V_{vo}$, also die Spannungsamplitude des Potentials VO gegenüber Masse, EnLsSync sowie SENSE, deren Bedeutung anhand Fig. 2 erläutert ist, hinsichtlich eines Übergangs von Rezirkulationsphase zu Einschaltphase. Der erste Mess-Zyklus des Sigma-Delta-Modulators 13 nach dem Beginn der Einschaltphase ist durch "First Sample" veranschaulicht und erfolgt nach Schließen des Ausgangsschalters 122, welcher durch Signal EnLsSync angesteuert wird. In Fig. 5 ist beispielhaft ein Übergang von Einschaltphase zu Rezirkulationsphase anhand der Signalverläufe VDRVEN, $V_{vo}$, EnHsSync und REDUN veranschaulicht, welche anhand der Fig. 3 erläutert sind.

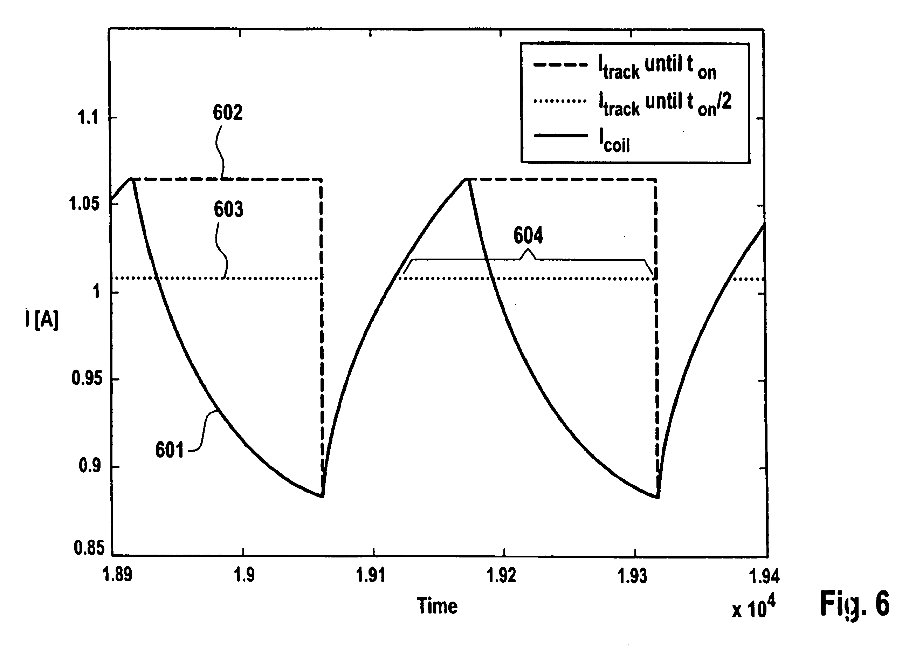

Der Signalverlauf in Fig. 6 zeigt den Laststrom 601 ($I_{coil}$) und zwei auf unterschiedliche Weise ermittelte, den Messstrom repräsentierende Signalverläufe 602 und 603 einer Strommessung mit Haltephase. Das Messdiagramm stammt von einer Schaltung, welche lediglich einen Ansteuer-FET umfasst und bei der der Laststrom über eine externe Freilaufdiode rezirkuliert. Bei Kurve 603 beginnt die Haltephase 604, bei der ein Stromwert gespeichert wird (flacher Teil der Kurve) bei einer Zeit, die etwa der Hälfte der Einschaltphase ($t_{on}$/2) entspricht. Die Haltephase von Kurve 602 beginnt erst nach vollständigem Ablauf der Einschaltphase ($t_{on}$). Beide Strommesskurven springen zu Beginn einer neuen Einschaltphase auf den Anfangswert des zu diesem Zeitpunkt anliegenden Ansteuerstroms (in Fig. 6 bei etwa 0,89 A).

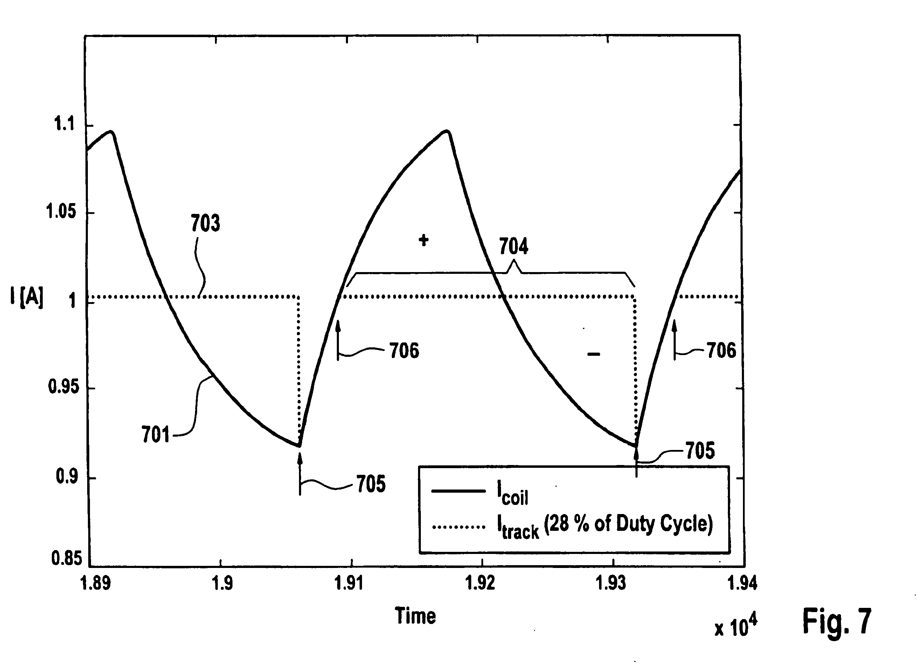

Der Signalverlauf in Fig. 7 zeigt den Laststrom 701 ($I_{coil}$) und einen den Messstrom repräsentierenden Signalverlauf 703, wenn die Haltephase 704, bei der ein Stromwert gespeichert wird (flacher Teil der Kurve) bei einer Zeit beginnt, die etwa 28 Prozent des Tastgrads entspricht (Zeitpunkt Pfeil 706). Sie endet entsprechend Fig. 4 mit dem Ende der Ansteuerphase (Pfeil 705). Um den Formfehler vollständig zu beseitigen, wäre es an sich erforderlich, den gesamten Stromverlauf einschließlich Ansteuer- und Rezirkulationsphase möglichst vollständig abzutasten. In einer einfach gehaltenen Schaltung mit nur einem Ansteuertreiber ohne Rezirkulationstreiber (zum Beispiel mit einer oder mehreren externen, zur Strommessung schwerlich nutzbaren Freilaufdioden) ist dies jedoch nicht ohne weiteres möglich. Das Verfahren, den Messstrom ab einem Tastgrad von ca. 28 Prozent über einen Teil der restlichen Ansteuerphase und über die ganze Rezirkulationsphase konstant zu halten, bringt durch die ähnlich großen Integralflächen (Plus-Symbol und Minus-Symbol in Fig. 7), die sich aus der Differenz des Effektivstroms und des Messstroms ergeben, welche sich gegenseitig im wesentlichen aufheben, eine überraschend hohe Genauigkeit der Strommessung auch bei unterschiedlichen Lasten und Randbedingungen. Die einfach gehaltene mehrkanalige Schaltung kommt dabei bevorzugt mit nur einem externen Messwiderstand aus, wenn als Ansteuertransistor ein Sense-FET verwendet wird.

**Patentansprüche**

1. Elektronisches Kraftfahrzeugregelungssystem mit mindestens einer Ventilansteuerungsschaltung (2a, 2b), welche mittels einer Puls-Weiten-Modulation einen Laststrom regelt, und mit mindestens einer elektronischen Strommessschaltung, die zumindest einen Messpfad (1, 3) mit wenigstens einem Analog-Digital-Wandler (13, 33) aufweist, der ein analoges Messsignal des Laststroms in ein digitales Messsignal des Laststroms umwandelt und so angesteuert wird oder ausgebildet ist, dass er mehrere Strommessungen pro PWM-Periode durchführt, **dadurch gekennzeichnet, dass**

   der wenigstens eine Messpfad (1, 3) der Strommessschaltung eine Signal-Konservations-Schaltung (12, 32) aufweist, welche das analoge Messsignal des Laststroms für zumindest eine definierte Haltezeit ($t_{off \to on}$, $t_{on \to off}$) im Wesentlichen unverändert und unabhängig von dem tatsächlichen Laststrom bereitstellt wobei die Signal-Konservations-Schaltung (12, 32) zumindest einen Eingangs- (121, 321) und wenigstens einen Ausgangsschalter (122, 322) aufweist, wobei mit dem Eingangsschalter (121, 321) die Signal-Konservations-Schaltung (12, 32) von dem Laststrom getrennt werden kann und mit dem Ausgangsschalter (122, 322) die Signal-Konservations-Schaltung (12, 32) von dem Analog-Digital-Wandler (13, 33) getrennt werden kann.

2. Kraftfahrzeugregelungssystem nach Anspruch 1, **dadurch gekennzeichnet, dass** der jeweilige Analog-Digital-Wandler (13, 33) als Sigma-Delta-Modulator ausgebildet ist.

3. Kraftfahrzeugregelungssystem nach Anspruch 1 oder 2, **dadurch gekennzeichnet, dass** der zumindest eine Messpfad (1, 3) der elektronischen Strommessschaltung eine Eingangsschaltung umfasst, die wenigstens einen Sense-FET (111, 311), insbesondere einen Sense-Verstärker (112, 312), aufweist, welcher das analoge Messsignal des Laststroms in Abhängigkeit des Laststroms bereitstellt.

4. Kraftfahrzeugregelungssystem nach mindestens einem der Ansprüche 1 bis 3, **dadurch gekennzeichnet, dass** der wenigstens eine Analog-Digital-Wandler (13, 33) zumindest ein Speicherelement (131, 331), welches wenigstens eine Information über das analoge Messsignal des Laststroms direkt oder indirekt speichern kann, und wenigstens einen Schalter (132, 332) umfasst, wobei mittels dieses Schalters (132, 332) das Speicherelement (131, 331) isoliert werden kann und insbesondere der Analog-Digital-Wandler (13, 33) außer Funktion gesetzt werden kann.

5. Kraftfahrzeugregelungssystem nach mindestens einem der Ansprüche 1 bis 4, **dadurch gekennzeichnet, dass** die elektronische Strommessschaltung zumindest einen Einschaltpfad (1) und/oder wenigstens einen Rezirkulationspfad (3) als Messpfade aufweist, wobei zumindest einer oder beide jeweils wenigstens einen Analog-Digital-Wandler (13, 33) umfassen und eine Signal-Konservations-Schaltung (12, 32).

6. Kraftfahrzeugregelungssystem nach Anspruch 5, **dadurch gekennzeichnet, dass** der Einschaltpfad (1) und/oder der Rezirkulationspfad (3) der Strommessschaltung jeweils eine Eingangsschaltung (11, 31) aufweisen, die so angesteuert wird/werden, dass die Eingangsschaltung (11) im Wesentlichen nur während der Einschaltphase und/oder der Ausschaltphase den tatsächlichen Laststrom diesem Messpfad (1) direkt oder indirekt bereitstellt.

**7.** Kraftfahrzeugregelungssystem nach Anspruch 6, **dadurch gekennzeichnet, dass** Schaltungsmittel vorgesehen sind, mit denen die Laststrombereitstellung nur während eines Teils der Einschalt- und/oder Ausschaltphase bereitgestellt wird.

**8.** Kraftfahrzeugregelungssystem nach mindestens einem der Ansprüche 1 bis 7, **dadurch gekennzeichnet, dass** die Eingangsschaltung den Strom des Einschaltpfads oder des Rezirkulationspfades nur für eine bestimmte vorgegebene Zeitspanne bereitstellt, welche insbesondere mit dem Beginn einer jeden PWM-Periode startet.

**9.** Kraftfahrzeugregelungssystem nach Anspruch 8, **dadurch gekennzeichnet, dass** der Strom im Einschaltpfad ab Beginn einer jeden PWM-Periode gemessen und weitergeleitet wird und die Haltephase, bei der die Konservationsschaltung genutzt wird, zu einem vorgegebenen Zeitpunkt beginnt, welcher zwischen einiger Zeit nach Beginn der PWM-Periode und einiger Zeit vor dem Ablauf der Einschaltphase liegt.

**10.** Kraftfahrzeugregelungssystem nach Anspruch 5 oder 6, **dadurch gekennzeichnet, dass** die elektronische Strommessschaltung eine Umschalteinheit und eine gemeinsame Mittelwertbildungseinrichtung aufweist, wobei die Ausgänge (SENSE, REDUN) des Einschaltpfades (1) und/oder des Rezirkulationspfades (3) mit den Eingängen der Umschalteinheit verbunden sind und der Ausgang der Umschalteinheit mit dem Eingang der gemeinsamen Mittelwertbildungseinrichtung.

**11.** Verfahren zur Strommessung in einem elektronischen Kraftfahrzeugregelungssystem, welches in mindestens einer Ventilansteuerungsschaltung (2a, 2b) einen Laststrom mittels Puls-Weiten-Modulation regelt, wobei das Verfahren insbesondere mit einem Kraftfahrzeugregelungssystem gemäß mindestens einem der Ansprüche 1 bis 10 durchgeführt wird und wobei das Kraftfahrzeugregelungssystem eine elektronische Strommessschaltung aufweist, welche zumindest einen Messpfad (1, 3) mit wenigstens einem Analog-Digital-Wandler (13, 33) umfasst, der ein analoges Messsignal des Laststroms in ein digitales Messsignal des Laststroms umwandelt und so angesteuert wird oder ausgebildet ist, dass er mehrere Strommessungen pro PWM-Periode durchführt, **dadurch gekennzeichnet, dass** in dem wenigstens einen Messpfad (1, 3) das analoge Messsignal des Laststroms zumindest für eine definierte Haltezeit ($t_{off \to on}$, $t_{on \to off}$) im Wesentlichen unverändert und unabhängig von dem während dieser Haltezeit ($t_{off \to on}$, $t_{on \to off}$) tatsächlich fließenden Laststrom, durch jeweils eine Signal-Konservations-Schaltung (12, 32) bereitgestellt wird, wobei beim Umschalten zwischen den PWM-Phasen ein Eingangsschalter (121, 321) der Signal-Konservations-Schaltung (12, 32) des Messpfades geöffnet wird, welcher der gerade beendeten PWM-Phase zugeordnet ist, wodurch das analoge Messsignal des Laststroms dieses PWM-Pfades im Wesentlichen für die definierte Haltezeit ($t_{off \to ont}$ $t_{on \to off}$) unverändert bereitgestellt wird, wobei nach dieser definierten Haltezeit ein Ausgangsschalter (122, 322) dieser Signal-Konservations-Schaltung (12, 32) geöffnet wird und damit das analoge Messsignal oder eine von diesem abhängige elektrische Größe direkt oder indirekt für die Dauer der gerade begonnenen PWM-Phase zuzüglich der sich an diese PWM-Phase anschließenden Haltezeit gespeichert wird.

**12.** Verfahren nach Anspruch 11, **dadurch gekennzeichnet, dass** der Laststrom während einer Einschaltphase und/oder einer Rezirkulationsphase der PWM gemessen wird und die elektronische Strommessschaltung hierzu zumindest einen Einschaltpfad (1) und/oder wenigstens einen Rezirkulationspfad (3) als Messpfade aufweist, welche jeweils wenigstens einen Analog-Digital-Wandler (13, 33) und eine Signal-Konservations-Schaltung (12, 32) umfassen.

**13.** Verfahren nach Anspruch 12, **dadurch gekennzeichnet, dass** der Laststrom nur während eines Teils der Einschalt- und/oder Ausschaltphase bestimmt und/oder als Strommesssignal weitergegeben wird.

**14.** Verfahren nach Anspruch 12, **dadurch gekennzeichnet, dass** die Messung oder Weitergabe des tatsächlich gemessenen Stroms mit dem Beginn einer jeden PWM-Periode startet.

**15.** Verfahren nach Anspruch 13 **dadurch gekennzeichnet, dass** die sich an die Strommessphase anschließende Haltephase, bei der ein konstanter Wert weitergegeben wird, zu einem vorgegebenen Zeitpunkt beginnt, welcher zwischen einiger Zeit nach Beginn der PWM-Periode und einiger Zeit vor dem Ablauf der Einschaltphase liegt.

**16.** Verfahren nach Anspruch 11, **dadurch gekennzeichnet, dass** jeweils beim Umschalten zwischen den PWM-Phasen, direkt zu Beginn einer jeweiligen PWM-Phase, der Eingangsschalter (121, 321) der Signal-Konservations-Schaltung (12, 32) des jeweiligen PWM-Pfades (1, 3) geschlossen wird und der Ausgangsschalter (122, 322) dieser Signal-Konservations-Schaltung (12, 32) des einen PWM-Pfades (1, 3) jeweils im Wesentlichen dann geschlossen wird, wenn der Ausgangsschalter (322, 122) der Signal-Konservations-Schaltung (32, 12) des anderen PWM-Pfades (3, 1) geöffnet wird.

**17.** Verfahren nach Anspruch 11 oder 16, **dadurch gekennzeichnet, dass** jeweils im Wesentlichen zeitgleich mit dem Öffnen des Ausgangsschalters (122, 322) der Signal-Konservations-Schaltung (12, 32) eines der Messpfade (1, 3) ein Schalter (132, 332) des Analog-Digital-Wandlers (13, 33) dieses Messpfades ebenfalls geöffnet wird und damit ein Speicherelement (131, 331) dieses Analog-Digital-Wandlers isoliert wird und insbesondere dieser Analog-Digital-Wandler (13, 33) außer Funktion gesetzt wird, wobei dieser Schalter (131, 331) dieses Analog-Digital-Wandlers auch im Wesentlichen zeitgleich mit dem Ausgangsschalter (122, 322) der Signal-Konservations-Schaltung (12, 32) dieses Messpfades (1, 3) wieder geschlossen wird oder wieder zusätzlich ansteuerbar wird.

**18.** Verfahren nach Anspruch 11 oder 16, **dadurch gekennzeichnet, dass** die digitalen Messsignale der PWM-Pfade (1, 3) im Wesentlichen innerhalb des Zeitintervalls, in welchem der Ausgangsschalter (122, 322) der Signal-Konservations-Schaltung (12, 32) des jeweiligen PWM-Pfades (1, 3) geschlossen ist, an eine gemeinsame Auswerteschaltung übertragen oder von dieser berücksichtigt werden, wobei das Ausgangssignal dieser gemeinsamen Auswerteschaltung zumindest die Information über die Amplitude des gemessenen Laststroms, insbesondere jeweils hinsichtlich einer PWM-Periode, beinhaltet.

**19.** Verwendung des Kraftfahrzeugregelungssystems gemäß mindestens einem der Ansprüche 1 bis 10 in einem Kraftfahrzeugbremssystem.

**Claims**

**1.** Electronic motor vehicle control system having at least one valve actuation circuit (2a, 2b), which uses pulse width modulation to control a load current, and having at least one electronic current measuring circuit, which has at least one measurement path (1, 3) with at least one analog/digital converter (13, 33) which converts an analog measurement signal for the load current into a digital measurement signal for the load current and is actuated or designed such that it performs a plurality of current measurements per PWM period, **characterized in that** the at least one measurement path (1,3) of the current measuring circuit has a signal conservation circuit (12, 32) which provides the analog measurement signal for the load current for at least a defined hold time ($t_{off \to on}$, $t_{on \to off}$) in essentially unaltered form and independently of the actual load current, wherein the signal conservation circuit (12, 32) has at least one input switch (121, 321) and at least one output switch (122, 322), wherein the input switch (121, 321) can be used to isolate the signal conservation circuit (12, 32) from the load current, and the output switch (122, 322) can be used to isolate the signal conservation circuit (12, 32) from the analog/digital converter (13, 33).

**2.** Motor vehicle control system according to Claim 1, **characterized in that** the respective analog/digital converter (13, 33) is in the form of a sigma/delta modulator.

**3.** Motor vehicle control system according to Claim 1 or 2, **characterized in that** the at least one measurement path (1, 3) of the electronic current measuring circuit comprises an input circuit which has at least one sense FET (111, 311), particularly a sense amplifier (112, 312), which provides the analog measurement signal for the load current on the basis of the load current.

**4.** Motor vehicle control system according to at least one of Claims 1 to 3, **characterized in that** the at least one analog/digital converter (13, 33) comprises at least one memory element (131, 331), which can store at least one information item about the analog measurement signal for the load current directly or indirectly, and at least one switch (132, 332), wherein this switch (132, 332) can be used to isolate the memory element (131, 331) and particularly to deactivate the analog/digital converter (13, 33).

**5.** Motor vehicle control system according to at least one of Claims 1 to 4, **characterized in that** the electronic current measuring circuit has at least one switch-on path (1) and/or at least one recirculation path (3) as measurement paths, wherein at least one or both respectively comprise at least one analog/digital converter (13, 33) and a signal conservation circuit (12, 32).

**6.** Motor vehicle control system according to Claim 5, **characterized in that** the switch-on path (1) and/or the recirculation path (3) of the current measuring circuit respectively have an input circuit (11, 31) which is/are actuated such that the input circuit (11) provides the actual load current for said measurement path (1) directly or indirectly essentially only during the switched-on phase and/or the switched-off phase.

**7.** Motor vehicle control system according to Claim 6, **characterized in that** circuit means are provided which are used to provide the load current provision only during a portion of the switched-on and/or switched-off phase.

**8.** Motor vehicle control system according to at least one of Claims 1 to 7, **characterized in that** the input circuit provides the current for the switch-on path or the recirculation path only for a particular prescribed time period which starts particularly at the beginning of each PWM period.

9. Motor vehicle control system according to Claim 8, **characterized in that** the current in the switch-on path is measured and forwarded from the beginning of each PWM period, and the hold phase in which the conservation circuit is used begins at a prescribed time which is between some time after the beginning of the PWM period and some time before the expiry of the switched-on phase.

10. Motor vehicle control system according to Claim 5 or 6, **characterized in that** the electronic current measuring circuit has a changeover unit and a common averaging device, wherein the outputs (SENSE, REDUN) of the switch-on path (1) and/or of the recirculation path (3) are connected to the inputs of the changeover unit, and the output of the changeover unit is connected to the input of the common averaging device.

11. Method for current measurement in an electronic motor vehicle control system which controls a load current in at least one valve actuation circuit (2a, 2b) by means of pulse width modulation, wherein the method is carried out particularly using a motor vehicle control system according to at least one of Claims 1 to 10 and wherein the motor vehicle control system has an electronic current measuring circuit which comprises at least one measurement path (1, 3) having at least one analog/digital converter (13, 33) which converts an analog measurement signal for the load current into a digital measurement signal for the load current and is actuated or designed such that it performs a plurality of current measurements per PWM period, **characterized in that** the analog measurement signal for the load current is provided in the at least one measurement path (1, 3) by a respective signal conservation circuit (12, 32) at least for a defined hold time ($t_{off \to on}$, $t_{on \to off}$) in essentially unaltered form and independently of the load current actually flowing during this hold time ($t_{off \to on}$ $t_{on \to off}$), wherein the changeover between the PWM phases involves an input switch (121, 321) of the signal conservation circuit (12, 32) of the measurement path which is associated with the PWM phase just finished being opened, as a result of which the analog measurement signal for the load current in this PWM path is provided in unaltered form essentially for the defined hold time ($t_{off \to on}$, $t_{on \to off}$), wherein this defined hold time is followed by an output switch (122, 322) of this signal conservation circuit (12, 32) being opened and hence the analog measurement signal or an electrical variable which is dependent thereon being stored directly or indirectly for the duration of the PWM phase just begun plus the hold time which follows this PWM phase.

12. Method according to Claim 11, **characterized in that** the load current is measured during a switched-on phase and/or a recirculation phase of the PWM, and the electronic current measuring circuit to this end has at least one switch-on path (1) and/or at least one recirculation path (3) as measurement paths which respectively comprise at least one analog/digital converter (13, 33) and a signal conservation circuit (12, 32).

13. Method according to Claim 12, **characterized in that** the load current is determined and/or forwarded as a current measurement signal only during a portion of the switched-on and/or switched-off phase.

14. Method according to Claim 12, **characterized in that** the measurement or forwarding of the actually measured current starts at the beginning of each PWM period.

15. Method according to Claim 13, **characterized in that** the hold phase, which follows the current measuring phase and in which a constant value is forwarded, begins at a prescribed time which is between some time after the beginning of the PWM period and some time before the expiry of the switched-on phase.

16. Method according to Claim 11, **characterized in that** the respective changeover between the PWM phases involves, directly at the start of a respective PWM phase, the input switch (121, 321) of the signal conservation circuit (12, 32) of the respective PWM path (1, 3) being closed and the output switch (122, 322) of this signal conservation circuit (12, 32) of the one PWM path (1, 3) respectively being closed essentially when the output switch (322, 122) of the signal conservation circuit (32, 12) of the other PWM path (3, 1) is opened.

17. Method according to Claim 11 or 16, **characterized in that** in each case essentially at the same time as the output switch (122, 322) of the signal conservation circuit (12, 32) of one of the measurement paths (1, 3) is opened, a switch (132, 332) of the analog/digital converter (13, 33) of this measurement path is likewise opened and hence a memory element (131, 331) of this analog/digital converter is isolated and particularly this analog/digital converter (13, 33) is deactivated, wherein this switch (132, 332) of this analog/digital converter is also closed again or becomes additionally actuatable again essentially at the same time as the output switch (122, 322) of the signal conservation circuit (12, 32) of this measurement path (1, 3).

**18.** Method according to Claim 11 or 16, **characterized in that** the digital measurement signals for the PWM paths (1, 3) are transmitted to a common evaluation circuit or are taken into account by the latter essentially within the time interval in which the output switch (122, 322) of the signal conservation circuit (12, 32) of the respective PWM path (1, 3) is closed, wherein the output signal from this common evaluation circuit contains at least the information about the amplitude of the measured load current, particularly for a respective PWM period.

**19.** Use of the motor vehicle control system according to at least one of Claims 1 to 10 in a motor vehicle brake system.

**Revendications**

**1.** Système électronique de régulation de véhicule automobile avec au moins un circuit de commande de soupapes (2a, 2b) qui règle un courant de charge au moyen d'une modulation de largeur d'impulsions, et avec au moins un circuit électronique de mesure de courant comportant au moins un chemin de mesure (1, 3) avec au moins un convertisseur analogique-numérique (13, 33) qui convertit un signal analogique de mesure du courant de charge en un signal numérique de mesure du courant de charge et qui est ainsi commandé ou conçu de manière à exécuter plusieurs mesures de courant par période de PWM, **caractérisé en ce que**

au moins un chemin de mesure (1, 3) du circuit de mesure de courant comporte un circuit de conservation du signal (12, 32) qui met à disposition le signal analogique de mesure du courant de charge pour au moins une durée de maintien définie ($t_{off \rightarrow on}$, $t_{on \rightarrow off}$) sans modification significative et indépendamment du courant de charge réel, le circuit de conservation du signal (12, 32) comportant au moins un commutateur d'entrée (121, 321) et au moins un de sortie (122, 322), le commutateur d'entrée (121, 321) permettant de déconnecter le circuit de conservation du signal (12, 32) vis à vis du courant de charge et le commutateur de sortie (122, 322) permettant de déconnecter le circuit de conservation du signal (12, 32) vis à vis du convertisseur analogique-numérique (13, 33).

**2.** Système de régulation de véhicule automobile selon la revendication 1, **caractérisé en ce que** le convertisseur analogique-numérique (13, 33) est conçu sous la forme d'un modulateur sigma-delta.

**3.** Système de régulation de véhicule automobile selon la revendication 1 ou 2, **caractérisé en ce qu'**au moins un chemin de mesure (1, 3) du circuit électronique de mesure de courant comprend un circuit d'entrée comportant au moins un FET de détection (111, 311), notamment un amplificateur de détection (112, 312) qui fournit le signal analogique de mesure du courant de charge en fonction du courant de charge.

**4.** Système de régulation de véhicule automobile selon une au moins des revendications 1 à 3, **caractérisé en ce qu'**au moins un convertisseur analogique-numérique (13, 33) comporte au moins un élément de mémoire (131, 331) capable de mémoriser directement ou indirectement au moins une information concernant le signal analogique de mesure du courant de charge, et au moins un commutateur (132, 332), ce commutateur (132, 332) permettant d'isoler l'élément de mémoire (131, 331) et permettant notamment de mettre hors fonction le convertisseur analogique-numérique (13, 33).

**5.** Système de régulation de véhicule automobile selon une au moins des revendications 1 à 4, **caractérisé en ce que** le circuit électronique de mesure de courant comporte comme chemin de mesure au moins un chemin de mise en route (1) et/ou au moins un chemin de recirculation (3), au moins un ou les deux comprenant respectivement au moins un convertisseur analogique-numérique (13, 33) et un circuit de conservation du signal (12, 32).

**6.** Système de régulation de véhicule automobile selon la revendication 5, **caractérisé en ce que** le chemin de mise en route (1) et/ou le chemin de recirculation (3) du circuit de mesure de courant comportent respectivement un circuit d'entrée (11, 31) qui est/sont commandé(s) de telle sorte que le circuit d'entrée (11) ne fournit directement ou indirectement le courant de charge réel à ce chemin de mesure (1) pour l'essentiel que pendant la phase de mise en route et/ou la phase d'arrêt.

**7.** Système de régulation de véhicule automobile selon la revendication 6, **caractérisé en ce que** des moyens de commutation sont prévus permettant la fourniture du courant de charge uniquement pendant une partie de la phase de mise en route et/ou d'arrêt.

**8.** Système de régulation de véhicule automobile selon une au moins des revendications 1 à 7, **caractérisé en ce que** le circuit d'entrée ne fournit le courant du chemin de mise en route ou du chemin de recirculation uniquement pendant une durée définie prédéterminée commençant notamment avec le début de chaque période de PWM.

**9.** Système de régulation de véhicule automobile selon la revendication 8, **caractérisé en ce que** le courant dans le chemin de mise en route est mesuré et acheminé à partir du commencement de chaque période de PWM et la phase d'arrêt pour laquelle on utilise le circuit de conservation, commence à un instant prédéterminé situé entre quelque temps après le début de la période de PWM et quelque temps avant l'expiration de la phase de mise en route.

10. Système de régulation de véhicule automobile selon la revendication 5 ou 6, **caractérisé en ce que** le circuit électronique de mesure de courant comporte une unité de commutation et un dispositif commun de formation de la valeur moyenne, les sorties (SENSE, REDUN) du chemin de mise en route (1) et/ou du chemin de recirculation (3) étant reliées aux entrées de l'unité de commutation et la sortie de l'unité de commutation étant reliée à l'entrée du dispositif commun de formation de la valeur moyenne.

11. Procédé de mesure de courant dans un système électronique de régulation de véhicule automobile qui règle un courant de charge au moyen d'une modulation de largeur d'impulsions dans au moins un circuit de commande de soupapes (2a, 2b), le procédé s'exécutant notamment avec un système de régulation de véhicule automobile selon au moins une des revendications 1 à 10 et le système de régulation de véhicule automobile comportant un circuit électronique de mesure de courant comprenant au moins un chemin de mesure (1, 3) avec au moins un convertisseur analogique-numérique (13, 33) qui convertit un signal analogique de mesure du courant de charge en un signal numérique de mesure du courant de charge et qui est ainsi commandé ou conçu de manière à exécuter plusieurs mesures de courant par période de PWM, **caractérisé en ce que** dans au moins un chemin de mesure (1, 3) le signal analogique de mesure du courant de charge est mis à disposition respectivement par l'intermédiaire d'un circuit de conservation du signal (12, 32) pour au moins une durée de maintien définie ($t_{off \to on}$, $t_{on \to off}$) sans modification significative et indépendamment du courant de charge circulant réellement pendant cette durée de maintien ($t_{off \to on}$, $t_{on \to off}$), un commutateur d'entrée (121, 321) du circuit de conservation du signal (12, 32) du chemin de mesure affecté à la phase de PWM juste terminée s'ouvrant lors de la commutation entre les phases de PWM, le signal analogique de mesure du courant de charge de ce chemin de PWM étant mis à disposition pour la durée de maintien définie ($t_{off \to on}$, $t_{on \to off}$) sans modification significative, un commutateur de sortie (122, 322) de ce circuit de conservation du signal (12, 32) s'ouvrant après cette durée de maintien définie et mémorise ainsi le signal analogique de mesure ou une grandeur électrique qui en dépend directement ou indirectement, pour la durée de la phase de PWM qui vient de commencer majorée de la durée de maintien suivant cette phase de PWM.

12. Procédé selon la revendication 11, **caractérisé en ce qu'**on mesure le courant de charge pendant une phase de mise en route et/ou une phase de recirculation de la PWM et le circuit électronique de mesure de courant comporte à cet effet comme chemin de mesure au moins un chemin de mise en route (1) et/ou au moins un chemin de recirculation (3) comprenant respectivement au moins un convertisseur analogique-numérique (13, 33) et un circuit de conservation du signal (12, 32).

13. Procédé selon la revendication 12, **caractérisé en ce que** le courant de charge n'est défini que pendant une partie de la phase de mise en route et/ou de la phase d'arrêt, et/ou transmis comme signal de mesure du courant.

14. Procédé selon la revendication 12, **caractérisé en ce que** la mesure ou la transmission du courant effectivement mesuré commence avec le début de chaque période de PWM.

15. Procédé selon la revendication 13, **caractérisé en ce que** la phase de maintien suivant la phase de mesure pendant laquelle on transmet une valeur constante commence à un instant prédéterminé situé entre quelque temps après le début de la période de PWM et quelque temps avant l'expiration de la phase de mise en route.

16. Procédé selon la revendication 11, **caractérisé en ce que** respectivement lors de la commutation entre les phases de PWM, directement au début d'une phase de PWM respective, on ferme le commutateur d'entrée (121, 321) du circuit de conservation du signal (12, 32) du chemin de PWM respectif (1, 3) et on ferme alors pour l'essentiel le commutateur de sortie (122, 322) respectif de ce circuit de conservation du signal (12, 32) d'un de ces chemins de PWM (1, 3) lorsqu'on ouvre le commutateur de sortie (322, 122) du circuit de conservation du signal (32, 12) de l'autre chemin de PWM (3, 1).

17. Procédé selon la revendication 11 ou 16, **caractérisé en ce que** respectivement pour l'essentiel simultanément avec l'ouverture du commutateur de sortie (122, 322) du circuit de conservation du signal (12, 32) d'un des chemins de mesure (1, 3), on ouvre également un commutateur (132, 332) du convertisseur analogique-numérique (13, 33) de ce chemin de mesure et ce qui isole ainsi un élément de mémoire (131, 331) de ce convertisseur analogique-numérique et qui met notamment hors fonction le convertisseur analogique-numérique (13, 33), en même temps qu'on ferme à nouveau ou qu'on commande de plus à nouveau ce commutateur (132, 332) de ce convertisseur analogique-numérique pour l'essentiel simultanément avec le commutateur de sortie (122, 322) du circuit de conservation du signal (12, 32) de ce chemin de mesure (1, 3).

**18.** Procédé selon la revendication 11 ou 16, **caractérisé en ce que** pour l'essentiel à l'intérieur de l'intervalle de temps pendant lequel le commutateur de sortie (122, 322) du circuit de conservation du signal (12, 32) du chemin de PWM (1, 3) respectif est fermé, les signaux numériques de mesure des chemins de PWM (1, 3) sont transmis à, ou sont pris en compte par un circuit d'exploitation commun, le signal de sortie de circuit d'exploitation commun contient au moins l'information concernant l'amplitude du courant de charge mesuré, respectivement concernant notamment une période de PWM.

**19.** Utilisation du système de régulation de véhicule automobile selon une au moins des revendications 1 à 10 dans un système de freinage de véhicule automobile.

Fig. 1

Fig. 2

EP 2 265 478 B1

Fig. 3

Fig. 4

Fig. 5

EP 2 265 478 B1

Fig. 6

Fig. 7

EP 2 265 478 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10057486 A1

- DE 102007001458 A1